Europäisches Patentamt

European Patent Office

Office européen des brevets

(11) Publication number: **0 311 399**
**A2**

## (12) EUROPEAN PATENT APPLICATION

(21) Application number: 88309320.5

(22) Date of filing: 06.10.88

(51) Int. Cl.⁴: **G 03 F 7/00**

(30) Priority: 08.10.87 US 106202

(43) Date of publication of application:
12.04.89 Bulletin 89/15

(84) Designated Contracting States: **DE FR GB**

(71) Applicant: **THE MEAD CORPORATION**
**2000 Courthouse Plaza NE**
**Dayton Ohio 45463 (US)**

(72) Inventor: **Beery, Jack**
**7128 Hunters Creek Drive**
**Centerville Ohio 45459 (US)**

**Boyer, David A.**
**121 North Tenth Street**
**Miamisburg Ohio 45342 (US)**

(74) Representative: **Deans, Michael John Percy et al**
**Lloyd Wise, Tregear & CO. Norman House 105-109 Strand**
**London WC2R OAE (GB)**

(54) Registering to a moving web.

(57) A method is described for registering to an imaging web moving within an imaging web handling apparatus along an imaging web path. The imaging web comprises a support having a coating of photosensitive microcapsules on the surface thereof. The photosensitive microcapsules have an internal phase of a photosensitive composition and a colour former associated therewith. Exposure of the imaging web to actinic radiation defines an image area and a border area. A registration mark is formed on the web by exposing a portion of the web area to actinic radiation from a source so that the portion undergoes a colour or reflection change, or exposing all but a portion of the border area to actinic radiation so that the exposed area undergoes a colour or reflection change. The registration mark is detected and, in response to detection of the registration mark, an operation is performed on the imaging web.

FIG-3

EP 0 311 399 A2

**Description**

## REGISTERING TO A MOVING WEB

The present invention relates generally to web handling methods and apparatus, and more particularly, to such methods and apparatus in which operations performed on the web must be properly registered with the web.

A number of web-handling devices are known in which proper registration of the web with another web, with sheets, or with the device itself is required. The exact function of these devices depends upon the nature of the web material which is to be handled, as well as the particular operation to be carried out.

One type of web material is disclosed in US-A-4 399 209 and 4 440 846, which describe an imaging medium for use with an imaging system. The imaging medium comprises a support having a coating of photosensitive microcapsules on the surface thereof. The microcapsules contain an internal phase of a photosensitive composition and have a colour former associated therewith. The photosensitive microcapsules are image-wise exposed to actinic radiation and subjected to a uniform rupturing force whereupon the microcapsules rupture and image-wise release the internal phase. When the microcapsules rupture, the colour former image-wise reacts with a developer material and produces a colour image. In the embodiments described in the referenced patents, the microcapsules are typically ruptured by passing an image-wise exposed imaging web through the nip between a pair of parallel calender rolls.

This photosensitive medium may exist in a form which comprises two sheet-like layers. The microcapsules are carried on a first substrate layer which is most conveniently provided in the form of a continuous web. The developer material is typically coated onto a second separate support in the form of separate sheets wherein each sheet is referred to as a receiver sheet. The imaging web is subjected to the actinic radiation and the exposed microcapsule layer is then brought into contact with the developer layer of the receiver sheets. The receiver sheet and imaging web are developed by pressure with the finished image being formed in the receiver sheet.

It will be readily recognized that when the receiver sheet is brought into contact with the imaging web, the receiver sheet must be accurately registered with the web; otherwise, the finished image will be formed on the receiver sheet in an offset or misaligned position. Once the donor web has been exposed to actinic radiation, the location of the image on the web has been fixed. Thus, the receiver sheet must be properly positioned with respect to the imaging web in order to correspond to the exposed image.

A variety of registration systems which operate on moving webs are known. For example, see US-A-3 439 176 and 4 532 596 (register control when printing on a web); US-A-3 645 619 (register control when positioning film in reproduction apparatus); US-A-3 820 884 (register control when searching on a roll of microfilm); and US-A-4 519 868 (register control when cutting a roll of labels). In general, for such registration systems to operate properly, accurate data concerning the positioning of the web must be available. For example, in the case of the photosensitive media described above, both the positioning of the exposed portion of the web with respect to the web, and the overall positioning of the web with respect to the apparatus must be known in order for the sheet to be brought properly into position.

A significant problem is encountered in registering receiver sheets with the imaging web of the media described above. This problem results from the fact that the imaging web must be stationary at the exposure station where the image is exposed onto the imaging web. At the same time, developing is best carried out by continuously moving the imaging web and receiver sheet through the pressure rolls. Rapid and frequent starting and stopping of the imaging web during movement through the pressure rolls can affect the uniformity of the pressure applied to the imaging web which adversely affects the developing process. Thus, advancing of the imaging web between separate exposures, and advancing the imaging web through the developer rolls, are most advantageously done independently.

It is known to monitor the positioning of a moving imaging web by connecting a rotary positional encoder with the drive used for moving the imaging web. However, this approach is effective only where the entire web-handling apparatus is operated by a common drive. In the case of microencapsulated photosensitive media, the web may be advanced from the exposure station independent of the developer station. The web may also be retracted at the exposure station independent of the developer station. As an example, the web may be directed into a web reservoir after leaving the exposure station. The web in the web reservoir may then be reversed so that the gap between adjacent image areas is small for economical reasons, and as such, registration of the web at the exposure station is required. Also, the receiver sheet, which must be brought into contact with the web at the developer station, is registered in accordance with the exposure provided at the exposure station on the imaging web. Thus, it is not possible to monitor web position in the conventional manner using an encoder.

Although it is known in the printing art to print a visible registration mark, the formation of a visible registration mark in the aforementioned photosensitive imaging web would be useless for web re-registration or receiver sheet registration purposes. Although the image-wise exposure generates a latent image in the photosensitive imaging web, the latent image is not developed into a visible image on the receiver sheet until after the web has been re-registered or the receiver sheet is already in contact with the imaging web.

A system for registering sheets with a moving web which can be used in a web handling apparatus in which operations are performed on the web independent of each other is needed. The system needs to be capable of registering sheets with the web at a second station based upon operations on the web at a first station. Specifically, the system should be usable with a photosensitive web which is exposed at the first station and registered with a receiver sheet at the second station.

In meeting this need, which previously went wholly unsatisfied, the present invention provides a method of registering to an imaging web moving within an imaging web handling apparatus along an imaging web path. The imaging web comprises a support having a coating of photosensitive microcapsules on the surface thereof. The photosensitive microcapsules have an internal phase of a photosensitive composition and having a colour former associated herewith. Exposure of the imaging web at an exposure station to actinic radiation defines an image area and a border area.

We have found that upon exposure of the photosensitive microcapsules to actinic radiation, the photosensitive microcapsules undergo a detectable colour and/or reflection change. More specifically, upon exposure to actinic radiation, the internal phase of the photosensitive microcapsule shrinks as a result of polymerization. This shrinking results in a detectable colour and/or reflection change. As a result of the foregoing, we have found that a registration mark can be formed by exposure of the web to actinic radiation to generate a detectable colour or reflection change so as to provide a means of registration. More specifically, the registration mark can be formed at a position fixed relative to the image area so that upon reversing or advancing the web and later detection of the registration mark by a detector, the position of the image area on the imaging web is known in order for proper registration.

The invention provides, in a first aspect thereof, a method of registering to an imaging web moving within an imaging web handling apparatus along an imaging web path, said imaging web comprising a support having a coating of photosensitive microcapsules on the surface thereof, said photosensitive microcapsules having an internal phase of a photosensitive composition and having a colour former associated therewith, and exposure of said imaging web at an exposure station to actinic radiation defining an image area and a border area; the method being characterised in comprising the steps of: forming a registration mark on said imaging web by exposing a first portion of said image area perimeter or said border area to actinic radiation so that said first portion undergoes a colour or reflection change with respect to a remaining second portion of said image area perimeter or said border area; detecting said registration mark; and, in response to detecting said registration mark, performing an operation on said imaging web.

The exact location, shape, and size of the registration mark can be varied as long as a detector can detect a difference between the registration mark and the surrounding web area. As examples of potential locations for the registration mark, the registration mark can be formed on the perimeter of the image areas ("natural" registration mark); or in the web border areas which comprise the areas between the ends of adjacent image areas, and the areas between the sides of image areas and the web edge ("artificial" registration mark). The term "natural" registration mark as used herein means a registration mark made on the image area perimeter as a natural result of image-wise exposure to create the image area. The term ("artificial" registration mark as used herein means a registration mark made in the border area which is not the natural result of the image-wise exposure. The registration mark is formed on the web by exposing a first portion of the image area perimeter or the border area to actinic radiation so that the first portion undergoes a colour or reflection change with respect to the remaining second portion of the image area perimeter or the border area. In one embodiment, the first portion is small relative to the second portion and the registration mark is formed by exposing the first portion of the image area perimeter or the border area to actinic radiation so that the first portion undergoes a color or reflection change; as such, when the imaging web subsequently passes beneath a detector, the detector senses a difference between the registration mark, which comprises an exposed area having undergone a color or reflection change, and the surrounding unexposed area.

In another embodiment, the second portion is small relative to the first portion and the registration mark is formed by exposing the first portion of the image area perimeter or the border area to actinic radiation so that the first portion undergoes a color or reflection change; as such, when the imaging web subsequently passes beneath a detector, the detector detects a difference between the registration mark, which comprises an unexposed area, and the surrounding area, which comprises an exposed area having undergone a color or reflection change. So, depending upon the application, the registration mark can be defined by an exposed or unexposed area.

Depending upon the application, the registration mark can be formed at any location within the imaging web handling apparatus. As examples, the registration mark can be formed before, at, or after the image-wise exposure station. Also, the registration mark can be formed simultaneously with the image areas or at a different time. Because of this wide latitude, methods according to the invention can be used wherever registration to an imaging web is required.

In response to detection of the registration mark by the detector, an operation is performed on the imaging web. For example, if the imaging web is directed into a web reservoir after image area and registration mark formation, the web in the reservoir may then be reversed so that the gap between adjacent image areas is small for economical reasons. In response to detection of the registration mark by the detector, the web would be stopped and image-wise exposed to create the next image area.

In another example, the operation performed on the imaging web would be feeding a receiver sheet into contact with the imaging web so as to correspond with the image area. Thus, upon subsequent development, the final image is properly positioned on the receiver sheet.

As another example, in response to detection of the registration mark by the detector, a bar code or number would be applied to the web.

Another embodiment involves a transfer imaging process. An imaging web is image-wise exposed to actinic radiation to form an image area. The imaging web comprises a support having a coating of photosensitive microcapsules on the surface thereof. The photosensitive microcapsules have an internal phase of a photosensitive composition and a colour former. The image-wise exposure defines a border area in the imaging web comprising the areas of the imaging web surrounding the image area.

A natural or artificial registration mark is formed by exposure of the web to actinic radiation. The web is advanced and the registration mark is then detected with a detector. In response to detection of the registration mark, a receiver sheet is fed into contact with the imaging web along the image area. The entire surface of the imaging web is then subjected to a uniform rupturing force such that the photosensitive microcapsules rupture and release the internal phase in accordance with the image-wise exposure to react with a developer material to produce an image.

In accordance with a second and alternative aspect of this present invention we provide an apparatus for exposing an imaging web, registering with said imaging web, and developing the image areas of said imaging web, said imaging web comprising a support having a coating of photosensitive microcapsules on the surface thereof, said photosensitive microcapsules having an internal phase of a photosensitive composition and having a colour former associated therewith; said apparatus comprising: an exposure station, positioning means adapted for operatively positioning said imaging web at said exposure station, exposure means at said exposure station adapted for image-wise exposure of said photosensitive microcapsules on said imaging web such that an image area is formed and a border area is defined comprising the areas of said imaging web surrounding said image area, a developer station positioned beyond said exposure station and including developer means, and means adapted for operatively advancing said imaging web along a web path from said exposure station to said developer station; said apparatus being characterised in that it further comprises: mark forming means positioned adjacent to said web path before said developer station and adapted for operative exposure of said border area to form a registration mark, a detector positioned along said web path after said mark forming means and before said developer station and adapted for operatively detecting said registration mark and for generating a detector signal in response thereto, control means connected to said detector for operatively receiving said detector signal, and performing means connected to said control means and adapted to perform an operation on said imaging web in response to a detector signal being received by said control means.

In order that the present invention may be more fully understood, reference is now made to the accompanying drawings, in which:

Figs. 1A-1C are schematic illustrations in cross-section of an imaging web and receiver sheet for which the present invention is especially adapted, illustrating the imaging web, exposure of the web, and development of the image in the receiver sheet;

Fig. 2 is a schematic diagram of an apparatus for operating on a moving web, including means in accordance with the present invention for registering receiver sheets to the moving imaging web; and

Figs. 3 and 4 are top views of an imaging web showing the image areas and registration marks thereon.

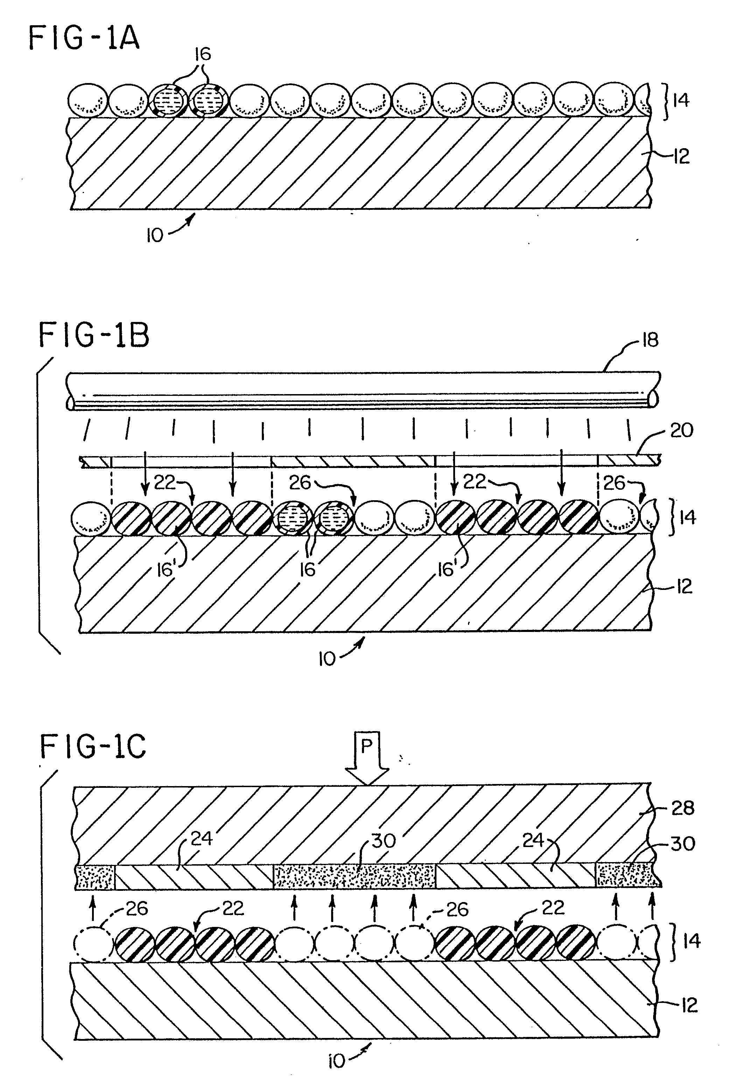

The method and apparatus of the present invention for registering receiver sheets to an imaging web moving within an imaging web handling apparatus along an imaging web path may be used in conjunction with the photosensitive imaging media described in US-A-4 399 209 and 4 440 846. The media can have a reflective surface such as provided by metallizing, or more specifically, by aluminizing. Such media can be seen by reference to Figs. 1A-1C, wherein an imaging web 10 is constituted by a substrate 12 coated with microcapsules 14. The microcapsules 14 are filled with an internal phase 16 containing a photosensitive composition. Typically, the photosensitive composition includes a photoinitiator. Preferred photoinitiators are disclosed in EP-A-223 587. Usually, the microcapsules 14 also contain a color former; however, the color former can be associated with the microcapsules 14 in other ways, such as by incorporation into the microcapsule wall or in a layer contiguous with the microcapsules.

While shown in Fig. 1A, in actuality, the microcapsules 14 are not visible to the unaided eye, since the mean size of the microcapsules generally ranges from approximately 1-25 microns.

Exposure of the imaging web 10 by transmission imaging is shown in Fig. 1B. A source of radiant energy 18 is positioned above the surface of the imaging web 10 with a mask 20 positioned therebetween. As illustrated, the substrate 12 is opaque and the photosensitive material within the microcapsules 14 is a positive working radiation curable material, i.e., the viscosity of the material increased upon exposure to actinic radiation.

The radiation of the exposed areas 22 causes the radiation curable composition in the internal phase 16 of the microcapsules 14 to polymerize, thereby gelling, solidifying, or otherwise immobilizing the color former and preventing the color former from reacting with the developer material 24. Preferred developer materials are disclosed in EP-A-260 129. To simplify the illustration, internal phase 16' in the exposed areas 22 is shown as a solid, whereas the internal phase 16 remains liquid in the unexposed areas 26.

The imaging web 10 is next processed by subjecting the imaging web to a uniform rupturing force by means of a pair of pressure rollers in resilient pressure engagement with the imaging web along a nip. The imaging web is moved between the rollers such that the rollers supply a uniform force to substantially the entire width of the imaging web to rupture the microcapsules 14 such that the color former contained within the microcapsules 14 or otherwise associated therewith can interact with the developer material 24.

As shown in Fig. 1C, the necessary developer material 24 is formed as a layer of developer material on a separate substrate or receiver sheet 28. The receiver sheet 28 is aligned and in facing engagement with the transfer imaging web 10. As the uniform rupturing force is applied by the pressure rollers to the combination of the transfer imaging web 10 and the receiver sheet 28, the microcapsules 14 are ruptured and the internal phase migrates to the developer layer 24 of the receiver sheet 28, where it reacts with the developer material to form the image 30.

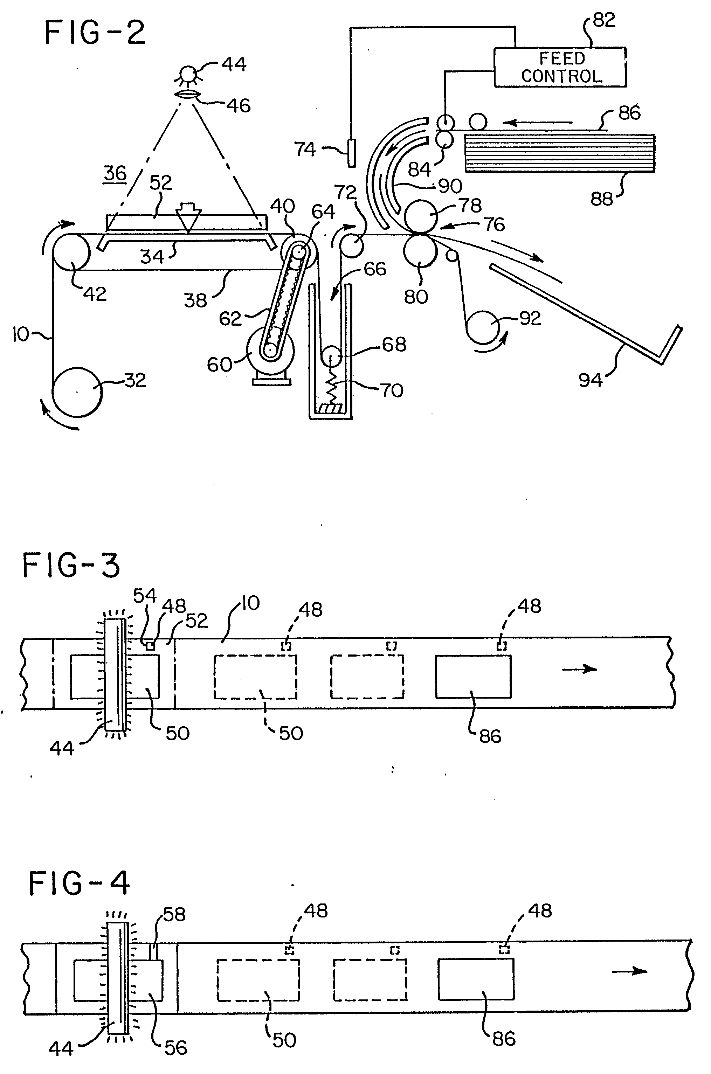

An apparatus with which the photosensitive media can be used is shown schematically in Fig. 2. The imaging web 10 is drawn from a supply roll 32 onto a platen 34 within an exposure station 36. In some situations, the platen 34 may be unnecessary because the web is just in tension. While within exposure station 36, imaging web 10 is located on an endless belt 38 extending around a drive roller 40 and an idler roller 42. When one frame, picture unit, or document is positioned at the exposure station 36, it is image-wise exposed to a source of actinic radiation 44 to form an image area on the imaging web 10. Preferably, the exposure is focused through lens 46. Typically, a screen, mask, baffle or the like is used to prevent exposure of the areas surrounding the image area, i.e., the border area. A useful means for preventing exposure of the border is disclosed in US-A-4 770 972.

Various forms of actinic radiation are useful in image-wise exposing the layer of photosensitive microcapsules 14 including ultraviolet radiation, infrared radiation, visible light, x-ray, and ion beam irradiation. Of course, the form selected is dependent upon the specific photosensitive composition selected. Any source of actinic radiation which can provide one of the foregoing forms of actinic radiation is useful in the image-wise exposure of the present invention. Preferably, the source of actinic radiation 44 provides broad band visible light. In Fig. 2, the source of actinic radiation 44 has been simplified for illustration purposes. Typically, a photomask (not shown in Fig. 2) or other means is used to provide the image information for exposure.

As an example of registration mark formation, a registration mark 48 as shown in Fig. 3 is preferably formed simultaneously with the image area at the exposure station 36. The exact location, shape, and size of the registration mark 48 can be varied as long as a detector can detect a difference between the registration mark 48 and the surrounding web area.

Thus, it should be understood that the location, shape, and size of the registration mark 48 as shown in Figs. 3 and 4 are for illustrative purposes only. Preferably, the registration mark 48 s formed in the border area between the edge of the imaging web 10 and the edge of the image area 50, rather than in the border area between the ends of adjacent image areas 50, so as to make the registration mark 48 more accessible to a detector.

As illustrated in Fig. 3, the same source of actinic radiation 44 can be used for both the image-wise exposure and the registration mark exposure. As shown in Fig. 3, suitable means such as a baffle 52 is placed so as to define the border area. The baffle 52 has an aperture 54 which corresponds to the desired location, shape, and size of the registration mark. As such, one exposure forms the image area 50 and the registration mark 48.

Although not illustrated, the registration mark 48 can also be formed before or after the image area 50 is formed and before, at, or after the exposure station. This method is less preferred because each registration mark may not necessarily be formed at precisely the same location relative to the image area due to the need to move the web between exposure locations if the registration mark is not formed at the exposure station. Also, if the registration mark 48 is formed at the same exposure station as the image area 50, the same source of actinic radiation can be used for both exposures. If the registration mark 48 is formed at a different location, another source of actinic radiation may be required. Comparable to the image-wise exposure, the form of actinic radiation selected for the separate registration mark exposure depends upon the specific photosensitive composition used. Preferably, a source of actinic radiation which provides visible light is used.

In the embodiment of Fig. 3, the registration mark 48 is formed by exposing a portion of the border area to actinic radiation so that the portion undergoes a color or reflection change. Alternatively, the registration mark 48 can be formed by exposing all but a portion of the border area to actinic radiation so that the exposed area undergoes a color or reflection change as shown in Fig. 4.

In one example of this technique, the same source of actinic radiation 44 is used for both the image-wise exposure and the non-registration mark border area exposure. As shown in Fig. 4, a photomask 56 is used to provide the image information for exposure. The photomask 56 has an extension 58 which shields the registration mark area from the actinic radiation. Extension 58 has a location, shape, and size which corresponds to the registration mark to be formed. It should be understood that extension 58 could also be separate from the photomask 56 as long as extension 58 blocks a portion of the border from the actinic radiation. As such, one exposure forms the image area 50 and the registration mark 48, which is the unexposed portion of the border. It should be understood that the registration mark 48, in the embodiment of Fig. 4, can also be generated before or after the formation of the image area 50 and before or after the exposure station.

Referring back to Fig. 2, belt 38 and hence imaging web 10 is driven at the exposure station 36 by motor 60, which is in turn connected to a toothed drive belt 62 passing around a toothed pulley 64 mounted at one end of roller 40.

As web 10 leaves the exposure station 36, it is directed into a web reservoir 66. There, the exposed imaging web 10 is accumulated, kept under tension by an appropriate dancer roll 68. Dancer roll 68 may be spring loaded by spring means 70 so as to provide sufficient downward force for maintaining web tension, and any appropriate dancer roll construction may be used.

In some applications, the direction of movement of the web 10 in the web reservoir 66 is reversed so that the unexposed area between the last area image-wise exposed and the next area to be image-wise exposed is small. In this application, the registration mark is formed on the perimeter of the last area image-wise exposed or in the surrounding border area; the registration mark can be formed either before or at the image-wise exposure station and either simultaneously with the last area image-wise exposed or at a different time. Although not illustrated, in this situation, a detector is situated between the web reservoir 66 and the exposure station 36. The web 10 is reversed until the detector senses the registration mark. A motor control means receives output from the detector upon the detection of the registration mark. The motor control means is in turn connected to the motor 60. The motor control means can be any appropriate control means for use with the motor 60 selected. It is sufficient to note that output from the detector is used to instruct motor control means to cause motor 60 to shut off so that the next area to be image-wise exposed can be exposed.

Upon emerging from reservoir 66, imaging web 10 is passed around a guide roll 72. A detector 74 is positioned above the imaging web 10 after the web 10 passes around the guide roll 72. Any conventionally used detector is useful in the present system as long as the detector does not damage the imaging web and can sense a difference between the registration mark and the surrounding border area. Preferably, an optical detector is used. A typical optical detector comprises a light source and a photoresponsive surface. The light source and the photoresponsive surface can be located together or spaced apart. A low level infrared detector is preferred. If the image area is in or near the deflector, either a baffle should be used to shield the image from the detector light or a detector should be used which has a wavelength which will not cause hardening of the photosensitive composition.

The imaging web 10 proceeds past the optical detector 74 and into the developer station 76. Typically, the web 10 travels toward a pair of parallel developer rolls 78 and 80 which define a pressure nip therebetween. Rolls 78 and 80 are counterrotated to draw imaging web 10 through the nip, and are specifically constructed to provide a uniform pressure across the entire length of the nip. Further details regarding rolls 78 and 80 can be seen by reference to US-A-4 768 050. Other useful means for rupturing microcapsules are disclosed in US-A-4 448 516; US-A-4 533 615; US-A-4 578 340; and US-A-4 592 986.

Receiving output from detector 74 upon the detection of a registration mark 48 is an appropriate feed control means 82. Feed control means 82 is in turn connected to the receiver sheet feed means 84. Feed control means 82 may be any appropriate control means for use with the particular receiver sheet feed means 84 selected. It is sufficient to note that output from detector 74 is used to instruct feed control means 82 to cause receiver sheet feed means 84 to supply a receiver sheet 86 from a storage bin 88 to the developer station 70. The receiver sheets 86 may be developer sheets, as shown in Fig. 1, which carry a layer of developer material which can react with the color former released upon the rupture of the microcapsules to produce a colored image. Alternatively, the receiver sheets 86 may be sheets of plain bond paper which receive the dye product of a color former and a developer material released from a self-contained imaging web.

Receiver sheet feed means 82 directs the receiver sheet 86 into an appropriate guide 90 which directs the receiver sheet 86 to the entrance to the nip between pressure rollers 78 and 80. Assuming that the receiver sheet feed means 84 has withdrawn a receiver sheet 86 from the storage bin 88 at the appropriate time, receiver sheet 86 will be delivered to the nip between pressure rollers 78 and 80 in proper registration with the image area 50 of imaging web 10 as shown in Figs. 3 and 4. The receiver sheet 86 and imaging web 10 then pass through the nip in superposed condition whereupon the microcapsules 14 on the imaging web 10 are ruptured so that the finished image is formed on the receiver sheet 86. Upon emerging from pressure rollers 78 and 80, the used imaging web 10 is collected on a take-up roll 92 while the receiver sheet 86 is directed into an appropriate receiver bin 94 or the like.

## Claims

1. A method of registering to an imaging web moving within an imaging web handling apparatus along an imaging web path, said imaging web comprising a support having a coating of photosensitive microcapsules on the surface thereof, said photosensitive microcapsules having an internal phase of a photosensitive composition and having a colour former associated therewith, and exposure of said imaging web at an exposure station to actinic radiation defining an image area and a border area; the method being characterised in comprising the steps of: forming a registration mark on said imaging web by exposing a first portion of said image area perimeter or said border area to actinic radiation so that said first portion undergoes a colour or reflection change with respect to a remaining second portion of said image area perimeter or said border area; detecting said registration mark; and, in response to detecting said registration mark, performing an operation on said imaging web.

2. A method according to Claim 1, further characterised in that said first portion is small relative to said second portion and said registration mark is formed by exposing said first portion of said image area perimeter or said border area to actinic radiation so that said first portion undergoes a colour or reflection change.

3. A method according to Claims 1 or 2, further characterised in that said registration mark is formed in said border area between the edge of said imaging web and the perimeter of said image area.

4. A method according to Claim 1, further characterised in that said second portion is small relative to said first portion and said registration mark is formed by exposing said first portion of said image area perimeter or said border area to actinic radiation so that said first portion undergoes a colour or reflection change.

5. A method according to any preceding claim, characterised in further comprising the step of advancing said web between the registration mark formation step and the registration mark detection step.

6. A method according to any preceding claim, further characterised in that the step of forming said registration mark is performed at said exposure station.

7. A method according to any preceding claim, further characterised in that said step of performing an operation on said imaging web comprises feeding a receiver sheet into contact with said imaging web along said image area.

8. A method according to any Claim 1 to 6, further characterised in that said step of performing an operation on said imaging web comprises stopping said imaging web and image-wise exposing said imaging web to actinic radiation.

9. An apparatus for exposing an imaging web, registering with said imaging web, and developing the image areas of said imaging web, said imaging web comprising a support having a coating of photosensitive microcapsules on the surface thereof, said photosensitive microcapsules having an internal phase of a photosensitive composition and having a colour former associated therewith; said apparatus comprising: an exposure station, positioning means adapted for operatively positioning said imaging web at said exposure station, exposure means at said exposure station adapted for image-wise exposure of said photosensitive microcapsules on said imaging web such that an image area is formed and a border area is defined comprising the areas of said imaging web surrounding said image area, a developer station positioned beyond said exposure station and including developer means, and means adapted for operatively advancing said imaging web along a web path from said exposure station to said developer station; said apparatus being characterised in that it further comprises: mark forming means positioned adjacent to said web path before said developer station and adapted for operative exposure of said border area to form a registration mark, a detector positioned along said web path after said mark forming means and before said developer station and adapted for operatively detecting said registration mark and for generating a detector signal in response thereto, control means connected to said detector for operatively receiving said detector signal, and performing means connected to said control means and adapted to perform an operation on said imaging web in response to a detector signal being received by said control means.

10. Apparatus according to Claim 9, further characterised in that said performing means comprises feeding means adapted operatively to feed receiver sheets into contact with said imaging web along said image area before or at said developer station.

11. Apparatus according to Claim 9, further characterised in that said exposure means and said mark forming means comprise a source of actinic radiation.

12. Apparatus according to Claim 11, further characterised in that said mark forming means is adapted to form said registration mark by exposing a portion of said image area perimeter or said border area to said source of actinic radiation so that said portion undergoes a colour or reflection change.

13. Apparatus according to Claim 11, further characterised in that said mark forming means is adapted to form said registration mark by exposing all but a portion of said image area perimeter or said border area to said source of actinic radiation so that said exposed area undergoes a colour or reflection change.

14. Apparatus according to any of Claims 9 to 13, further characterised in that said developer means is a pair of pressure rolls.

FIG-1A

FIG-1B

FIG-1C

FIG-2

FIG-3

FIG-4